# EUROPÄISCHE PATENTSCHRIFT

(11) **EP 4 189 837 B1**
(45) Veröffentlichungstag und Bekanntmachung des Hinweises auf die Patenterteilung: **03.09.2025**
(21) Anmeldenummer: 21758596.7
(22) Anmeldetag: 29.07.2021
(51) Int. Cl.: H04B 3/00, G01R 31/364, H02J 7/00

(54) **ANORDNUNG NICHTGALVANISCH GEKOPPELTER ELEKTRISCHER NETZWERKE UND VERFAHREN ZUM BETREIBEN**
ASSEMBLY OF NON-GALVANICALLY COUPLED ELECTRICAL NETWORKS AND METHOD FOR OPERATING SAME
ENSEMBLE DE RÉSEAUX ÉLECTRIQUES À COUPLAGE NON GALVANIQUE ET LEUR PROCÉDÉ DE FONCTIONNEMENT

(30) Priorität: 30.07.2020 DE 102020120133
(43) Veröffentlichungstag der Anmeldung: 07.06.2023
(73) Patentinhaber: Bexema GmbH, 39179 Magdeburg-Barleben (DE)
(72) Erfinder: BENECKE, Hannes, 39110 Magdeburg (DE); BENECKE, Robert, 39110 Magdeburg (DE)
(74) Vertreter: Maucher Jenkins Patent- und Rechtsanwälte
(86) Internationale Anmeldenummer: PCT/DE2021/100651
(87) Internationale Veröffentlichungsnummer: WO 2022/022781

(56) Entgegenhaltungen:
- WO-A2-2016/110833
- WO-A2-2016/110833
- US-A1- 2008 315 830
- US-A1- 2008 315 830

## Beschreibung

Die Erfindung betrifft eine Anordnung mit nichtgalvanisch untereinander gekoppelten Netzwerken, genauer gesagt, eine Anordnung aus zwei elektrischen Netzwerken und einer Koppeleinrichtung, mittels welcher diese beiden elektrischen Netzwerke, ohne die Schaffung einer galvanischen Verbindung zwischen ihnen, miteinander gekoppelt werden. Gegenstände der Erfindung sind dabei die entsprechende, in besonderer Weise ausgebildete Anordnung sowie ein Verfahren zum Betreiben dieser Anordnung.

Aus unterschiedlichen Gründen existieren in der Praxis technische Anordnungen, bei denen zwei oder gegebenenfalls mehr elektrische Netzwerke miteinander interagieren müssen oder sollen, ohne hierbei galvanisch, das heißt durch elektrische Leiter, miteinander verbunden zu sein. Sehr gebräuchlich sind beispielsweise Anordnungen, bei denen zwei elektrische Netzwerke beziehungsweise zwei elektronische Schaltungen aus dem Grund des Erfordernisses einer Potenzialtrennung (zum Beispiel Niederspannungsnetzwerk einerseits und elektrisches Netzwerk mit höherer Spannung oder gar Hochspannung andererseits) galvanisch voneinander getrennt, aber zur Ermöglichung eines Interagierens miteinander mit Hilfe eines Transformators oder eines Optokopplers ohne Aufhebung der galvanischen Trennung gekoppelt werden.

Jedoch bilden Systeme der vorgenannten Art und sich dieser bedienende Anwendungen nicht den Ausgangspunkt für die hier beanspruchte und im Folgenden beschriebene Erfindung. Eine galvanische Trennung zwischen elektrischen Netzwerken, die dennoch miteinander interagieren sollen, kann nämlich auch aufgrund einer großen Entfernung der Netzwerke voneinander und einer deshalb nicht praktikablen leitungsgebundenen Verbindung dieser Netzwerke gegeben sein oder auch aus sonstigen Gründen, welche eine direkte (das heißt leitungsgebundene) Verbindung entsprechender Netzwerke nahezu unmöglich machen oder jedenfalls aus praktischen Erwägungen heraus, nicht sinnvoll erscheinen lassen. In diesem Zusammenhang kann sich dabei das Zusammenwirken solcher elektrischen Netzwerke auch über den Fall einer remote erfolgenden digitalen Steuerung hinaus auf ein Zusammenspiel auf elektrisch analoger Ebene beziehen. US 2008/315830 A1 stellt den relevanten Stand der Technik dar.

Mit Blick auf den zuvor genannten Aspekt des Bestehens einer großen Entfernung zwischen miteinander interagierenden elektrischen Netzwerken ist zum Beispiel an den Fall eines unterschiedliche elektronische Komponenten an verteilten Standorten fertigenden Unternehmens zu denken. Für ein solches im Rahmen internationaler Arbeitsteilung gegebenenfalls auch multinational tätiges Unternehmen oder auch für verschiedene miteinander kooperierende Unternehmen kann es dabei beispielsweise erforderlich sein, vorab das Zusammenwirken zweier elektrischer Netzwerke zu simulieren und zu testen, welche zwar bei ihrem praktischen Einsatz galvanisch miteinander gekoppelt werden, so aber während ihrer Erprobung, beispielsweise aufgrund voneinander entfernter Entwicklungsstandorte, nicht betrieben werden können.

Aufgabe der Erfindung ist es, eine Lösung bereitzustellen, welche ein elektrisches Zusammenwirken nichtgalvanisch miteinander verbundener oder verbindbarer elektrischer Netzwerke ermöglicht. Hierzu sind eine entsprechende Anordnung bereitzustellen und ein mögliches Verfahren zum Betreiben dieser Anordnung anzugeben.

Die Aufgabe wird durch eine Anordnung mit den Merkmalen des Patentanspruchs 1 gelöst. Ein die Aufgabe lösendes, beim Betreiben einer solchen Anordnung ausgeführtes Verfahren wird durch den unabhängigen Verfahrensanspruch charakterisiert. Vorteilhafte Aus- und Weiterbildungen der Anordnung sind durch die Unteransprüche gegeben.

Die im Hinblick auf die vorstehende Aufgabe vorgeschlagene technische Lösung bezieht sich auf eine Anordnung nichtgalvanisch gekoppelter Netzwerke, welche aus zwei elektrischen Netzwerken und einer Koppeleinrichtung besteht. Mit der letztgenannten Koppeleinrichtung ist jedes der beiden elektrischen Netzwerke mit jeweils zwei Anschlusspunkten galvanisch verbunden. Dabei koppelt die Koppeleinrichtung die beiden elektrischen Netzwerke miteinander, ohne sie jedoch selbst untereinander galvanisch zu verbinden.

Erfindungsgemäß besteht die Koppeleinrichtung dazu aus zwei typischerweise voneinander entfernten, untereinander über mindestens eine Datenverbindung, aber nichtgalvanisch verbundenen Quellen/Senken. Hierbei handelt es sich um zwei sowohl als Quelle als auch als Senke betreibbare aktive elektrische Dipole (Zweipole). Die beiden aktiven elektrischen Dipole sind jeweils ausgestattet mit Messmitteln zur Messung von Stromstärke und Spannung, mit mindestens einer Steuer- und Verarbeitungseinrichtung (im Weiteren und in den Patentansprüchen zur sprachlichen Vereinfachung auch als SVE bezeichnet) und mit mindestens einer Datensende- und Empfangseinrichtung. Die aktiven elektrischen Dipole sind dabei dazu ausgebildet:
a.) gesteuert durch ihre jeweilige SVE (jeder aktive elektrische Dipol, respektive Zweipol, weist eine eigene SVE auf), für das jeweilige mit ihnen verbundene elektrische Netzwerk Strom und/oder Spannung entsprechend einem von dem jeweils anderen aktiven elektrischen Dipol empfangenen Sollwert bereitzustellen und
b.) die sich daraufhin an den Anschlusspunkten des mit dem sollwertempfangenden aktiven elektrischen Dipol galvanisch verbundenen elektrischen Netzwerks für Strom und/oder Spannung einstellenden Werte als Messwerte zu erfassen sowie diese Messwerte mittels ihrer SVE zu digitalisieren und
c.) digitalisierte Messwerte für Strom und/oder Spannung mittels ihrer Datensende- und Empfangseinrichtung an den jeweils anderen Dipol als Sollwert für die durch diesen Dipol ausgebildete Quelle/Senke zu übertragen.

Die (nichtgalvanische) Kopplung der beiden gegebenenfalls auch weit (beispielsweise viele, gegebenenfalls auch hunderte Kilometer voneinander) entfernten elektrischen Netzwerke erfolgt demnach nicht herkömmlich im elektrischen Sinne, sondern mit Hilfe einer Datenverbindung. Diese Datenverbindung besteht zwischen den beiden typischerweise im Wesentlichen genauso weit entfernten aktiven elektrischen Dipolen (Zweipolen), welche hier aufgrund ihres Zusammenwirkens gemeinsam als Koppeleinrichtung bezeichnet werden.

Aufgrund dessen, dass über die Datenverbindung Messwerte für Strom und/oder Spannung, welche an den mit der Koppeleinrichtung verbundenen Anschlusspunkten eines der elektrischen Netzwerke erfasst werden, an das jeweils andere elektrische Netzwerk als Sollwert übertragen und durch die mit ihm galvanisch verbundene Quelle/Senke, also durch den mit ihm galvanisch verbundenen Teil der Koppeleinrichtung, Strom und/oder Spannung entsprechend diesem Sollwert bereitgestellt werden und somit Strom und/oder Spannung durch eines der elektrischen Netzwerke dem jeweils anderen elektrischen Netzwerk gewissermaßen aufgeprägt werden, ist die so entstehende Anordnung hinsichtlich der sich einstellenden Verhältnisse vergleichbar mit einer Anordnung, bei welcher die beiden elektrischen Netzwerke direkt galvanisch miteinander verbunden sind. Wie im Rahmen der Erläuterungen zum Verfahren noch deutlich werden wird, tritt die letztgenannte Wirkung insbesondere dann ein, wenn Stromwerte und/oder Spannungswerte als Sollwerte wiederholt zwischen den beiden elektrischen Netzwerken über die Koppeleinrichtung mit der Datenverbindung ausgetauscht werden.

Der zuvor dargestellte lösungstechnische Ansatz ist in dieser Form grundsätzlich unabhängig davon anwendbar, ob es sich bei den beiden vermittels der Koppeleinrichtung nichtgalvanisch miteinander gekoppelten elektrischen Netzwerken um gleichstrom- oder um wechselstrombetriebene Netzwerke handelt. Allerdings gilt es zu berücksichtigen, dass die Art der Kopplung der Netzwerke mittels einer Datenverbindung und die im Zusammenhang damit erforderlichen Abläufe, wie beispielsweise die Digitalisierung der jeweils für Strom und/oder Spannung zu übertragenden Werte sowie die eigentliche Übertragung, eine gewisse Latenz mit sich bringen.

Selbstverständlich ist es möglich, diese Latenz bei der sich gemäß der Erfindung, entsprechend den vorstehenden Erläuterungen im Grunde zwischen den beiden elektrischen Netzwerken vollziehenden Synchronisation (Synchronisation hinsichtlich des Stroms und/oder der Spannung) zu berücksichtigen. Dies gilt jedenfalls dann, wenn die Latenz annähernd konstant ist. Je nach Entfernung der beiden elektrischen Netzwerke und der Art der in der Koppeleinrichtung zu deren Kopplung genutzten Datenverbindung ist jedoch eine solche Konstanz nicht immer gegeben, wobei außerdem die Übertragung der digitalisierten Messwerte für Strom und/oder Spannung auch Störungen unterworfen sein kann.

Vor diesem Hintergrund kann eine Kopplung von elektrischen Netzwerken mit sich, wie etwa bei einem Wechselstrombetrieb schnell ändernden Strom- und Spannungsverhältnissen unter Einsatz der erfindungsgemäßen Lösung schwierig oder gegebenenfalls auch gar nicht realisierbar sein. Daher liegt der Fokus der vorgeschlagenen Lösung insoweit auf einer als besonders praxisrelevant angesehenen Ausbildungsform, bei welcher es sich bei den beiden mittels der erfindungsgemäßen Koppeleinrichtung nichtgalvanisch gekoppelten elektrischen Netzwerken um gleichstrombetriebene Netzwerke handelt, beziehungsweise um Netzwerke in denen sich über gewisse Zeiträume hinweg stationäre oder quasistationäre Verhältnisse einstellen. Ausdrücklich sei jedoch darauf hingewiesen, dass die Erfindung hierauf nicht beschränkt ist.

Im Hinblick auf einen besonders bevorzugten Einsatzzweck ist bei einer möglichen Ausbildungsform der erfindungsgemäßen Anordnung eines der mittels der Koppeleinrichtung gekoppelten elektrischen Netzwerke als ein aktives Netzwerk mit einer Spannungsquelle und das andere Netzwerk als ein, eine elektrische Last für das aktive Netzwerk mit der Spannungsquelle darstellendes passives Netzwerk ausgebildet. Hierbei kann die Spannungsquelle in dem aktiven elektrischen Netzwerk oder eine Senke außerdem, je nach dem für das betreffende elektrische Netzwerk vorgesehenem Einsatzzweck, in unterschiedlichen Modi betrieben werden. Die Quelle/Senke kann dabei im Spannungsmode, mit einer bereitzustellenden konstanten Spannung, betrieben werden oder im Strommode, mit einem bereitzustellenden konstanten Strom, im Leistungsmode mit bereitzustellender konstanter Leistung oder im Widerstandsmode, bei dem sich die Quelle wie ein variabel einstellbarer, aber konstanter Widerstand verhält.

Insbesondere dann, wenn eines der miteinander gekoppelten elektrischen Netzwerke ein aktives Netzwerk mit einer im Leistungsmode betriebenen Spannungsquelle ist, kommt eine Ausbildungsform der erfindungsgemäßen Anordnung zum Einsatz, bei welcher die Quellen/Senken der Koppeleinrichtung als 4-Quadranten-Quellen/Senken ausgebildet sind. Bei 4-Quadranten-Quellen/Senken handelt es sich um elektronische Baugruppen, welche anders als klassische Netzgeräte, sowohl positive als auch negative Spannungen erzeugen sowie außerdem positive und negative Ströme für andere elektrische Einrichtungen/Baugruppen bereitstellen und - als Senke wirkend - von anderen elektrischen Einrichtungen/Baugruppen aufnehmen können.

Die erfindungsgemäße Anordnung kann vorteilhaft noch dadurch weitergebildet sein, dass mindestens eine der Quellen/Senken der Koppeleinrichtung über Mittel zur Aufzeichnung eines zeitlichen Verlaufs der von den Messmitteln erfassten, sich an den mit dem zugehörigen elektrischen Netzwerk gemeinsamen Anschlusspunkten jeweils für Strom und/oder Spannung einstellenden Werte verfügt. Entsprechendes ist insbesondere bei einer Ausbildung der Anordnung für Test- oder Simulationszwecke relevant, also im Zusammenhang mit Szenarien, bei welchen der Verlauf der zwischen den beiden elektrischen Netzwerken erfolgenden Synchronisation von Strom und/oder Spannung betrachtet und gegebenenfalls noch weiter ausgewertet werden soll.

Bei einer insoweit besonders vorteilhaften Weiterbildung verfügt daher mindestens eine der Quellen oder Senken der Koppeleinrichtung über Mittel zur Visualisierung der jeweils an den mit dem zugehörigen elektrischen Netzwerk gemeinsamen Anschlusspunkten für Strom und/oder Spannung gemessenen Werte und/oder ihres zeitlichen Verlaufs. Hierbei werden die entsprechenden Messwerte und/oder ihr zeitlicher Verlauf zum Zweck der Visualisierung durch die SVE der betreffenden Quelle/Senke des jeweiligen aktiven Zweipols (elektrischen Dipols), also des entsprechenden Teils der Koppeleinrichtung, aufbereitet.

Bei der mindestens einen, die beiden aktiven elektrischen Dipole der Koppeleinrichtung miteinander verbindenden Datenverbindung zur Übertragung der als Sollwerte dienenden digitalisierten Werte für Strom und/oder Spannung kann es sich beispielsweise um eine Mobilfunkverbindung oder um eine spezielle Datenfunkverbindung handeln. Unter Kostengesichtspunkten kann es sich insbesondere bei weit voneinander entfernten elektrischen, mittels der Koppeleinrichtung nichtgalvanisch gekoppelten Netzwerken, welche gegebenenfalls in unterschiedlichen Ländern oder gar auf unterschiedlichen Kontinenten angeordnet sind, auch um eine Internetverbindung handeln. Bei entsprechender Ausbildung und Konfiguration der in den aktiven elektrischen Dipolen der Koppeleinrichtung vorgesehenen, die Datenübertragung durch deren Sende- und Empfangseinrichtungen steuernden SVEs ist von der Erfindung auch die Möglichkeit umfasst, dass zwischen den aktiven Dipolen, gegebenenfalls auch gleichzeitig, mehrere, gegebenenfalls auch über unterschiedliche Medien realisierte Datenverbindungen bestehen.

Gemäß dem zur Lösung der Aufgabe vorgeschlagenen Verfahren erfassen die beiden aktiven elektrischen Dipole der Koppeleinrichtung an den Anschlusspunkten des jeweils mit ihnen galvanisch verbundenen elektrischen Netzwerks fortwährend Messwerte für Strom und/oder Spannung und übertragen diese nach einer Digitalisierung wechselweise an den jeweils anderen elektrischen Dipol als Sollwert für die durch diesen ausgebildete elektrische Quelle/Senke. Das heißt, die beiden Dipole synchronisieren, je nach Betriebsart (Spannungsmode, Strommode, Leistungsmode oder Widerstandsmode) fortwährend Strom und/oder Spannung untereinander, die sich hierdurch so einstellen, als seien die Netzwerke an ihren Anschlusspunkten zu der Koppeleinrichtung direkt galvanisch miteinander verbunden.

Selbstverständlich ist auch dieser Vorgang von der durch die Messung der Werte, ihre Digitalisierung und die Übertragung über die Datenverbindung bedingten Latenz beeinflusst, so dass sich ein in einem der Netzwerke ändernder Strom und/oder eine sich ändernde Spannung erst mit einer gewissen Verzögerung in dem jeweils anderen Netzwerk auswirkt. Aufgrund dessen, dass der andere den oder die Sollwerte empfangende Dipol die sich in Reaktion auf die Bereitstellung des jeweiligen Stroms und/oder der jeweiligen Spannung an den Anschlusspunkten seines zugehörigen elektrischen Netzwerks (als Systemantwort des betreffenden Netzwerks) einstellenden Werte seinerseits wiederum als Sollwerte an den jeweils anderen Dipol überträgt und sich auch der empfangende Teil der Anordnung hierauf mit einer gewissen Verzögerung einstellt, schwingt sich das gesamte System nach einer entsprechenden Änderung der Strom- und/oder Spannungsverhältnisse in einem der beiden elektrischen Netzwerke gewissermaßen ein.

Entsprechend einer möglichen Umsetzung des erfindungsgemäßen Verfahrens dient dieses dazu, die Interaktion zweier mittels der erfindungsgemäßen Koppeleinrichtung miteinander verbundenen elektrischen Netzwerke messtechnisch zu erfassen und zu beobachten. Ein möglicher Einsatzfall ist es insoweit, die sich bei der Interaktion zwischen einer Fahrzeugbatterie als Teil eines aktiven elektrischen Netzwerks und einem zumindest während der entsprechenden Prüfung entfernt davon angeordneten passiven elektrischen Netzwerk, zum Beispiel einem Elektromotor mit Umrichter, für Strom und Spannung einstellenden Verhältnisse, im Vorgriff auf das spätere Zusammenfügen dieser beiden Komponenten zu analysieren.

Die Erfindung soll nachfolgend anhand von Figuren in der Art eines Ausführungsbeispiels noch einmal näher erläutert werden. Die Zeichnungen zeigen im Einzelnen:
- Fig. 1:: ein Blockschaltbild einer möglichen Ausbildungsform der erfindungsgemäßen Anordnung,
- Fig. 2:: ein Diagramm mit den sich nach einer Zustandsänderung in einem der Netzwerke für Strom und Spannung einstellenden zeitlichen Verlauf,
- Fig. 3:: ein Symbolschaltbild für die bei der Anordnung gemäß Fig. 1 virtuell bestehende Konstellation.

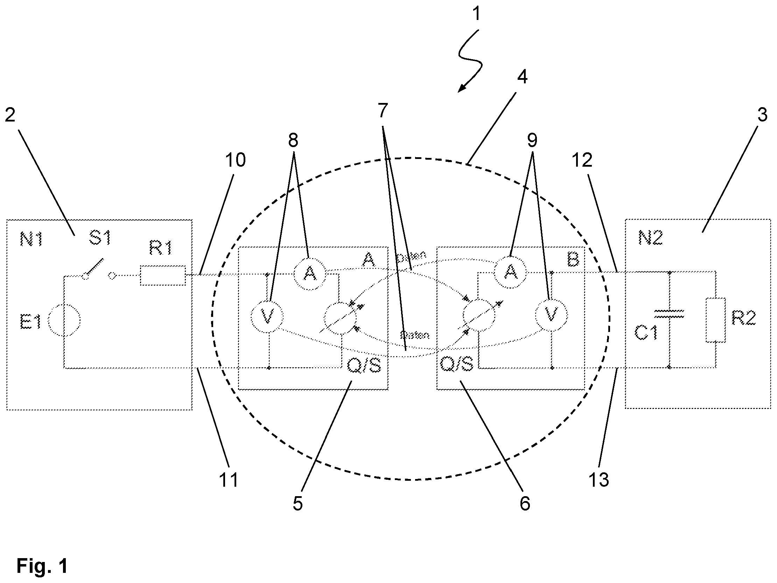

Die Fig. 1 zeigt ein grobes Blockschaltbild einer möglichen Ausbildungsform der erfindungsgemäßen Anordnung 1. Die Anordnung1 besteht aus dem ersten elektrischen Netzwerk 2 (N1), dem zweiten elektrischen Netzwerk3 (N2) und der die beiden elektrischen Netzwerke 2, 3 nichtgalvanisch miteinander verbindenden, aber dennoch koppelnden Koppeleinrichtung 4. Bei dem in der Fig. 1 gezeigten Beispiel handelt es sich bei dem links dargestellten elektrischen Netzwerk 2 (N1) um ein aktives Netzwerk mit einer Spannungsquelle. Hingegen ist das rechts dargestellte elektrische Netzwerk 3 (N2) ein passives Netzwerk, welches bei einer unmittelbaren galvanischen Verbindung beider Netzwerke 2, 3 im klassischen Sinne eine Last für die Spannungsquelle (E1) des aktiven Netzwerks 2 (N1) ausbildet. Durch die Erfindung und die spezielle Art der nichtgalvanischen Kopplung beider elektrischer Netzwerke 2, 3 wirkt aber bei der in der Figur gezeigten Anordnung das rechts dargestellte passive Netzwerk 3 (N2), trotz des Nichtbestehens einer galvanischen Verbindung zwischen den elektrischen Netzwerken 2, 3, ebenfalls als Last für das links dargestellte aktive elektrische Netzwerk 2 (N1).

Die Koppeleinrichtung 4 besteht aus zwei, jeweils sowohl als Quelle als auch als Senke betreibbaren aktiven elektrischen Dipolen 5, 6, welche untereinander nichtgalvanisch, aber durch eine Datenverbindung 7 verbunden, das heißt miteinander gekoppelt sind. Jeder dieser aktiven elektrischen Dipole 5, 6 verfügt über eine in der Zeichnung nicht gezeigte Steuer- und Verarbeitungseinrichtung (SVE), über eine (ebenfalls nicht dargestellte) Datensende- und Empfangseinrichtung zum Aufbau der bereits angesprochenen Datenverbindung und über Messmittel 8, 9 zur Erfassung von Strom und Spannung in dem jeweils zugeordneten elektrischen Netzwerk 2, 3. Das jeweilige elektrische Netzwerk 2, 3 ist mit dem jeweils zugehörigen Teil der Koppeleinrichtung 4 jeweils über zwei Anschlusspunkte 10, 11 respektive 12, 13 galvanisch verbunden.

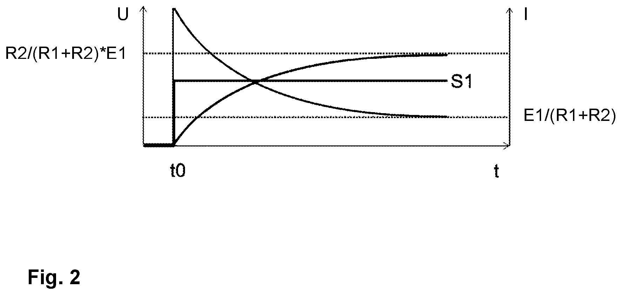

Die Fig. 2 zeigt die Strom- und Spannungsverhältnisse (mit Spannung = U und Strom[-stärke] = I), wie sich diese im zeitlichen Verlauf sowohl an den das (links dargestellte) aktive elektrische Netzwerk 2(N1) mit dem zugehörigen Teil der Koppeleinrichtung 4 verbindenden Anschlusspunkten 10, 11 als auch an den das (rechts dargestellte) passive elektrische Netzwerk 3 (N2) mit dem zugehörigen Teil der Koppeleinrichtung 4 verbindenden Anschlusspunkten 12, 13 nach dem Schließen des Schalters S1 in dem aktiven elektrischen Netzwerk 2, (N1) einstellen. Die entsprechenden Verhältnisse mit dem Endspannungswert R2/(R1+R2)*E1 und dem Endstromwert E1/(R1+R2) stellen sich in Abhängigkeit der Art der Datenverbindung 7 und der bei ihrer Nutzung gegebenen Latenz typischerweise innerhalb von etwa 0,5 ms bis 15,0 ms nach dem Schließen des Schalters S1 ein. Nach dem Schließen dieses Schalters S1 des aktiven elektrischen Netzwerks 2 (N1) mit der im Leistungsmode betriebenen Spannungsquelle E1 werden durch den zugehörigen Teil (aktiver elektrischer Dipol 5) der Koppeleinrichtung 4 mit Hilfe ihrer Messmittel 8 die Stromstärke (I) und die Spannung (U) gemessen. Die entsprechenden Messwerte werden von der (nicht dargestellten) SVE dieses Teils (aktiver elektrischer Dipol 5) der Koppeleinrichtung 4 digitalisiert und durch ihre (ebenfalls nicht gezeigte) Datensende- und Empfangseinrichtung an den anderen, mit dem (rechts dargestellten) passiven elektrischen Netzwerk 3 (N2) galvanisch verbundenen aktiven elektrischen Dipol 6 der Koppeleinrichtung 4 als Sollwerte übertragen. Der diese Sollwerte empfangende, eine Quelle/Senke ausbildende aktive elektrische Dipol 6 stellt Strom und Spannung entsprechend dieser Sollwerte für das passive elektrische Netzwerk 3 (N2) mit dem Widerstand R2 und dem dazu parallel geschalteten Kondensator C1 ein und misst dann seinerseits an den Anschlusspunkten 12, 13 zu diesem passiven elektrischen Netzwerk 3 (N2) die Stromstärke und die Spannung als Systemantwort, um deren digitalisierte Werte dann wiederum an den anderen, auf der linken Seite der Figur dargestellten, dem aktiven elektrischen Netzwerk 2 (N1) zugeordneten aktiven elektrischen Dipol 5 als Sollwerte zu übertragen. Dieser Zyklus wiederholt sich fortwährend mit einer sehr kurzen Zykluszeit (Mykrosekundenbereich), so dass sich dann die in der Fig. 2 dargestellten Verhältnisse einstellen.

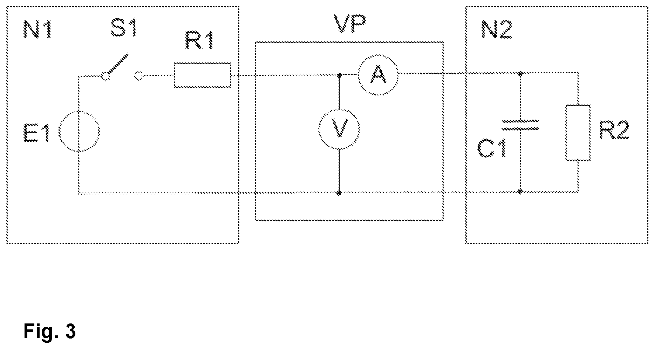

Die Fig. 3 zeigt ein Symbolschaltbild einer Konfiguration, wie sie gewissermaßen in virtueller Form durch die Anordnung gemäß der Fig. 1 ausgebildet wird. Demnach wirkt nämlich die Anordnung nach der Fig. 1 (die Latenzen vernachlässigt) so, als seien die beiden elektrischen Netzwerke galvanisch an ihren Anschlusspunkten über einen Vierpol miteinander verbunden. Aus der Darstellung wird dabei deutlich, dass durch die Koppeleinrichtung der erfindungsgemäßen, in der Fig. 1 gezeigten Anordnung gewissermaßen die Aufteilung eines Vierpols (wie in der Fig 3 symbolisch angegeben) in zwei aktive elektrische Dipole erfolgt. Um insoweit nicht den Eindruck entstehen zu lassen, bei der Konfiguration gemäß dem Symbolbild der Fig 3. Handele es sich um eine zur der Anordnung gemäß Fig. 1 alternative Ausbildungsform, ist in der Fig. 3 bewusst auf das Antragen von Bezugszeichen verzichtet worden.

## Patentansprüche

1. Anordnung (1) nichtgalvanisch gekoppelter Netzwerke (2, 3), mit zwei elektrischen Netzwerken (2, 3) und mit einer Koppeleinrichtung (4), über welche die beiden, mit jeweils zwei Anschlusspunkten (10, 11 und 12, 13) galvanisch mit der Koppeleinrichtung (4) verbundenen elektrischen Netzwerke (2, 3) miteinander gekoppelt sind, ohne selbst untereinander galvanisch verbunden zu sein, wobei die Koppeleinrichtung (4) besteht aus zwei untereinander, über mindestens eine Datenverbindung (7), aber nicht galvanisch verbundenen Quellen/Senken, nämlich aus zwei sowohl als Quelle als auch als Senke betreibbaren aktiven elektrischen Dipolen (5, 6), welche jeweils ausgestattetet sind mit Messmitteln (8, 9) für Strom und Spannung, mit mindestens einer Steuer- und Verarbeitungseinrichtung SVE und mit mindestens einer Datensende- und Empfangseinrichtung, **dadurch gekennzeichnet, dass** die beiden aktiven elektrischen Dipole (5, 6) dazu ausgebildet sind
a.) gesteuert durch ihre jeweilige SVE, für das jeweilige mit ihnen galvanisch verbundene elektrische Netzwerk (2, 3) Strom und/oder Spannung entsprechend einem dazu von dem jeweils anderen aktiven elektrischen Dipol (5, 6) empfangenen Sollwert bereitzustellen und
b.) die sich daraufhin an den Anschlusspunkten (10, 11 oder 12, 13) des mit einem sollwertempfangenden aktiven elektrischen Dipol (5, 6) galvanisch verbundenen elektrischen Netzwerkes (2, 3) für Strom und/oder Spannung einstellenden Werte als Messwerte zu erfassen und diese mittels ihrer jeweiligen SVE zu digitalisieren und
c.) digitalisierte Messwerte für Strom und/oder Spannung mittels ihrer jeweiligen Datensende- und Empfangseinrichtung über die Datenverbindung (7) an den jeweils anderen aktiven elektrischen Dipol (5, 6) als Sollwert für die durch diesen aktiven elektrischen Dipol (5, 6) ausgebildete Quelle/Senke zu übertragen.

2. Anordnung nach Anspruch 1, **dadurch gekennzeichnet, dass** es sich bei den elektrischen Netzwerken (2, 3) um gleichstrombetriebene elektrische Netzwerke (2, 3) handelt.

3. Anordnung nach Anspruch 1 oder 2, **dadurch gekennzeichnet, dass** die Quellen/Senken der aktiven elektrische Dipole (5, 6) jeweils als 4-Quadranten-Quellen/Senken ausgebildet sind, das heißt, es sich bei den Quellen/Senken um elektronische Baugruppen handelt, welche sowohl dazu ausgebildet sind, als Quelle wirkend, positive und negative Spannungen zu erzeugen sowie positive und negative Ströme bereitstellen als auch, als Senke wirkend, positive und negative Spannungen sowie positive und negative Ströme von anderen elektrischen Einrichtungen/Baugruppen aufzunehmen.

4. Anordnung nach einem der Ansprüche 1 bis 3, **dadurch gekennzeichnet, dass** mindestens einer der eine Quelle/Senke ausbildenden aktiven elektrischen Dipole (5, 6) über Mittel zur Aufzeichnung eines zeitlichen Verlaufs der von seinen Messmitteln (8, 9) erfassten, sich an den mit dem zugehörigen elektrischen Netzwerk (2, 3) gemeinsamen Anschlusspunkten (10, 11, 12, 13) jeweils für Strom und/oder Spannung einstellenden Werte verfügt.

5. Anordnung nach einem der Ansprüche 1 bis 4, **dadurch gekennzeichnet, dass** mindestens einer der eine Quelle/Senke ausbildenden aktiven elektrischen Dipole (5, 6) über Mittel zur Visualisierung der jeweils an den mit dem zugehörigen elektrischen Netzwerk (2, 3) gemeinsamen Anschlusspunkten (10, 11, 12, 13) für Strom und/oder Spannung gemessenen Werte und/oder ihres zeitlichen Verlaufs verfügt, wobei die Messwerte und/oder ihr zeitlicher Verlauf für die Visualisierung durch die SVE des entsprechenden Teils der Koppeleinrichtung (4) aufbereitet werden.

6. Anordnung nach einem der Ansprüche 1 bis 5, **dadurch gekennzeichnet, dass** eines der mittels der Koppeleinrichtung (4) gekoppelten elektrischen Netzwerke (2, 3) ein aktives Netzwerk (2) mit einer im Leistungsmode arbeitenden Spannungsquelle und das andere Netzwerk (3) ein, eine elektrische Last für das aktive Netzwerk (2) mit der Spannungsquelle ausbildendes passives Netzwerk ist.

7. Anordnung nach einem der Ansprüche 1 bis 6, **dadurch gekennzeichnet, dass** es sich bei einer die beiden aktiven elektrischen Dipole (5, 6), miteinander verbindenden Datenverbindung (7) um eine Mobilfunkverbindung handelt.

8. Anordnung nach einem der Ansprüche 1 bis 7, **dadurch gekennzeichnet, dass** es sich bei einer die beiden aktiven elektrischen Dipole (5, 6) miteinander verbindenden Datenverbindung (7) um eine Internetverbindung handelt.

9. Verfahren zum Betreiben einer Anordnung (1) nach Anspruch 1, nämlich einer Anordnung (1) nichtgalvanisch gekoppelter Netzwerke (2, 3) mit zwei elektrischen Netzwerken (2, 3) und mit einer Koppeleinrichtung (4), über welche die beiden, mit jeweils zwei Anschlusspunkten (10, 11 und 12, 13) galvanisch mit der Koppeleinrichtung (4) verbundenen elektrischen Netzwerke (2, 3) miteinander gekoppelt sind, ohne selbst untereinander galvanisch verbunden zu sein, wobei die Koppeleinrichtung (4) besteht aus zwei untereinander, über mindestens eine Datenverbindung (7), aber nicht galvanisch verbundenen Quellen/Senken, nämlich aus zwei sowohl als Quelle als auch als Senke betreibbaren aktiven elektrischen Dipolen (5, 6), welche jeweils ausgestattetet sind mit Messmitteln (8, 9) für Strom und Spannung, mit mindestens einer Steuer- und Verarbeitungseinrichtung SVE und mit mindestens einer Datensende- und Empfangseinrichtung, **dadurch gekennzeichnet, dass** die beiden aktiven elektrischen Dipole (5, 6) der Koppeleinrichtung (4) an den Anschlusspunkten (10, 11, 12, 13) des jeweils mit ihnen galvanisch verbundenen elektrischen Netzwerks (2, 3) fortwährend Messwerte für Strom und/oder Spannung erfassen und mittels ihrer jeweiligen SVE digitalisieren und dass die aktiven elektrischen Dipole (5, 6) die digitalisierten Messwerte wechselweise mittels ihrer jeweiligen Datensende- und Empfangseinrichtung über die Datenverbindung (7) an den jeweils anderen aktiven elektrischen Dipol (5, 6) als Sollwert für die durch diesen ausgebildete elektrische Quelle/Senke übertragen, so dass sich an den mit der Koppeleinrichtung (4) verbundenen Anschlusspunkten (10, 11, 12, 13) der beiden elektrischen Netzwerke (2, 3) Strom und/oder Spannung so einstellen, als seien die Netzwerke (2, 3) an diesen Anschlusspunkten (10, 11, 12, 13) galvanisch miteinander verbunden.

## Claims

1. Assembly (1) of non-galvanically coupled networks (2, 3), having two electrical networks (2, 3) and having a coupling device (4) via which the two electrical networks (2, 3), each having two connection points (10, 11 and 12, 13) galvanically connected to the coupling device (4), are coupled to one another without themselves being galvanically connected to one another, wherein the coupling device (4) consists of two sources/sinks connected to one another via at least one data connection (7) but not galvanically connected, specifically two active electrical dipoles (5, 6) that can be operated both as sources and as sinks, each of which is equipped with measuring means (8, 9) for current and voltage, having at least one control and processing device SVE and having at least one data transmission and reception device,
**characterized in that** the two active electrical dipoles (5, 6) are designed
a. to supply, controlled by their respective SVE, current and/or voltage to the respective electrical network (2, 3) galvanically connected to them in accordance with a setpoint value received for this purpose from the respective other active electrical dipole (5, 6), and
b. to detect the values for current and/or voltage that are then set at the connection points (10, 11 or 12, 13) of the electrical network (2, 3) for current and/or voltage that is galvanically connected to an active electrical dipole (5, 6) receiving a setpoint value as measured values and to digitize these by means of their respective SVE, and
c. to transmit digitized measured values for current and/or voltage by means of their respective data transmission and reception devices via the data connection (7) to the respective other active electrical dipole (5, 6) as a setpoint value for the source/sink formed by this active electrical dipole (5, 6).

2. Assembly according to claim 1, **characterized in that** the electrical networks (2, 3) are direct current-operated electrical networks (2, 3).

3. Assembly according to claim 1 or 2, **characterized in that** the sources/sinks of the active electrical dipoles (5, 6) are each designed as 4-quadrant sources/sinks, i.e., the sources/sinks are electronic assemblies which are designed both to act as sources, generating positive and negative voltages and supplying positive and negative currents, and to act as sinks, absorbing positive and negative voltages and positive and negative currents from other electrical devices/assemblies.

4. Assembly according to one of claims 1 to 3, **characterized in that** at least one of the active electrical dipoles (5, 6) forming a source/sink is provided with means for recording a time sequence of the values measured by its measuring means (8, 9) and obtained at the connection points (10, 11, 12, 13), which are common to the associated electrical network (2, 3), for in each case current and/or voltage.

5. Assembly according to one of claims 1 to 4, **characterized in that** that at least one of the active electrical dipoles (5, 6) forming a source/sink has means for visualizing the values measured at the connection points (10, 11, 12, 13) for current and/or voltage, which are common to the associated electrical network (2, 3), and/or their time sequence, wherein the measured values and/or their time sequence are processed for visualization by the SVE of the corresponding part of the coupling device (4).

6. Assembly according to one of claims 1 to 5, **characterized in that** one of the electrical networks (2, 3) coupled by means of the coupling device (4) is an active network (2) with a voltage source operating in power mode and the other network (3) is a passive network forming an electrical load for the active network (2) with the voltage source.

7. Assembly according to one of claims 1 to 6, **characterized in that** the data connection (7) connecting the two active electrical dipoles (5, 6) to each other is a mobile radio connection.

8. Assembly according to one of claims 1 to 7, **characterized in that** the data connection (7) connecting the two active electrical dipoles (5, 6) to each other is an internet connection.

9. Method for operating an assembly (1) according to claim 1, specifically an assembly (1) of non-galvanically coupled networks (2, 3) having two electrical networks (2, 3) and having a coupling device (4) via which the two electrical networks (2, 3), which are galvanically connected to the coupling device (4) with in each case two connection points (10, 11 and 12, 13), are coupled to each other without being galvanically connected to each other,
wherein the coupling device (4) consists of two sources/sinks connected to each other via at least one data connection (7) but not galvanically connected, specifically two active electrical dipoles (5, 6) that can be operated both as sources and as sinks, each of which is equipped with measuring means (8, 9) for current and voltage, having at least one control and processing device SVE and having at least one data transmission and reception device, **characterized in that** that the two active electrical dipoles (5, 6) of the coupling device (4) continuously detect measured values for current and/or voltage at the connection points (10, 11, 12, 13) of the electrical network (2, 3) in each case galvanically connected to them and digitize them by means of their respective SVE, and **in that** the active electrical dipoles (5, 6) transmit the digitized measured values alternately by means of their respective data transmission and reception devices via the data connection (7) to the respective other active electrical dipole (5, 6) as a setpoint value for the electrical source/sink formed by the latter, so that current and/or voltage are obtained at the connection points (10, 11, 12, 13) of the two electrical networks (2, 3) connected to the coupling device (4) as if the networks (2, 3) were galvanically connected to each other at these connection points (10, 11, 12, 13).

## Revendications

1. Disposition (1) de réseaux (2, 3) couplés de façon non galvanique, avec deux réseaux électriques (2, 3) et avec une installation de couplage (4) par laquelle les deux réseaux électriques (2, 3), reliés chacun galvaniquement par deux points de raccordement (10, 11 et 12, 13) à l'installation de couplage (4), sont couplés l'un avec l'autre sans être eux-mêmes en liaison galvanique l'un avec l'autre, dans laquelle l'installation de couplage (4) se compose de deux puits/sources reliés l'un à l'autre par au moins une connexion de données (7) mais pas de façon galvanique, c'est-à-dire de deux dipôles électriques actifs (5, 6) pouvant servir aussi bien de source que de puits, qui sont équipés chacun de moyens de mesure (8, 9) de l'intensité et de la tension, avec au moins une installation de commande et de traitement ICT et avec au moins une installation d'émission et de réception de données, **caractérisée en ce que** les deux dipôles électriques actifs (5, 6) sont conçus pour
a) fournir au réseau électrique (2, 3) qui leur est connecté en liaison galvanique, sous le contrôle de leur ICT respective, une intensité et/ou une tension correspondant à la valeur de consigne reçue de l'autre dipôle électrique actif (5, 6) et
b) acquérir comme valeurs de mesure les valeurs d'intensité et/ou de tension qui s'établissent ensuite aux points de connexion (10, 11 ou 12, 13) du réseau électrique (2, 3) en liaison galvanique avec un dipôle électrique actif (5, 6) recevant les valeurs de consigne et les numériser au moyen de leur ICT respective et
c) transmettre des valeurs de mesure numérisées d'intensité et/ou de tension à l'autre dipôle électrique actif (5, 6) via la connexion de données (7), au moyen de leur installation d'émission et de réception de données respective, comme valeur de consigne pour la source/le puits formé par ce dipôle électrique actif (5, 6).

2. Disposition selon la revendication 1, **caractérisée en ce que** les réseaux électriques (2, 3) sont des réseaux électriques (2, 3) fonctionnant sous courant continu.

3. Disposition selon la revendication 1 ou 2, **caractérisée en ce que** les sources/puits des dipôles électriques actifs (5, 6) sont conformés chacun comme une source/un puits à 4 quadrants, c'est-à-dire que les sources/puits sont des modules électroniques conçus aussi bien pour générer des tensions positives et négatives et fournir des intensités positives et négatives, quand ils servent de source, que pour recevoir des tensions positives et négatives et des intensités positives et négatives d'autres installations/groupes électriques quand ils servent de puits.

4. Disposition selon l'une des revendications 1 à 3, **caractérisée en ce qu'**au moins un des dipôles électriques actifs (5, 6) formant une source/un puits dispose de moyens pour enregistrer une évolution dans le temps des valeurs d'intensité et/ou de tension acquises par ses moyens de mesure (8, 9) qui s'établissent aux points de connexion (10, 11, 12, 13) communs avec le réseau électrique (2, 3) correspondant.

5. Disposition selon l'une des revendications 1 à 4, **caractérisée en ce qu'**au moins un des dipôles électriques actifs (5, 6) formant une source/un puits dispose de moyens pour visualiser les valeurs d'intensité et/ou de tension mesurées aux points de connexion (10, 11, 12, 13) communs avec le réseau électrique (2, 3) correspondant et/ou leur évolution dans le temps, les valeurs de mesure et/ou leur évolution dans le temps étant traitées en vue de la visualisation par le ICT de la partie correspondante de l'installation de couplage (4).

6. Disposition selon l'une des revendications 1 à 5, **caractérisée en ce qu'**un des réseaux électriques (2, 3) couplés au moyen de l'installation de couplage (4) est un réseau actif (2) doté d'une source de tension fonctionnant en mode de puissance et l'autre réseau (3) est un réseau passif formant une charge électrique pour le réseau actif (2) doté de la source de tension.

7. Disposition selon l'une des revendications 1 à 6, **caractérisée en ce qu'**une connexion de données (7) reliant entre eux les deux dipôles électriques actifs (5, 6) est une connexion de radiotéléphonie.

8. Disposition selon l'une des revendications 1 à 7, **caractérisée en ce qu'**une connexion de données (7) reliant entre eux les deux dipôles électriques actifs (5, 6) est une connexion par Internet.

9. Procédé de fonctionnement d'une disposition (1) selon la revendication 1, à savoir une disposition (1) de réseaux (2, 3) couplés de façon non galvanique, avec deux réseaux électriques (2, 3) et avec une installation de couplage (4) par laquelle les deux réseaux électriques (2, 3), reliés chacun galvaniquement par deux points de raccordement (10, 11 et 12, 13) à l'installation de couplage (4), sont couplés l'un avec l'autre sans être eux-mêmes en liaison galvanique l'un avec l'autre, dans laquelle l'installation de couplage (4) se compose de deux puits/sources reliés l'un à l'autre par au moins une connexion de données (7) mais pas de façon galvanique, c'est-à-dire de deux dipôles électriques actifs (5, 6) pouvant servir aussi bien de source que de puits, qui sont équipés chacun de moyens de mesure (8, 9) de l'intensité et de la tension, avec au moins une installation de commande et de traitement ICT et avec au moins une installation d'émission et de réception de données, **caractérisé en ce que** les deux dipôles électriques actifs (5, 6) de l'installation de couplage (4) acquièrent en continu des valeurs de mesure d'intensité et/ou de tension aux points de connexion (10, 11, 12, 13) du réseau électrique (2, 3) qui est en liaison galvanique respective avec eux et les numérisent à l'aide de leur ICT respective et **en ce que** les dipôles électriques actifs (5, 6) transmettent alternativement les valeurs de mesure numérisées au moyen de leur installation d'émission et de réception de données respective via la connexion de données (7) à l'autre dipôle électrique actif (5, 6) comme valeur de consigne pour la source/le puits formé par celui-ci, de sorte que s'établissent aux points de connexion (10, 11, 12, 13) des deux réseaux électriques (2, 3) connectés avec l'installation de couplage (4) une intensité et/une tension qui s'établiraient si les réseaux (2, 3) étaient en liaison galvanique l'un avec l'autre en ces points de connexion (10, 11, 12, 13).
